# FASCICULE DE BREVET EUROPEEN

(11) **EP 0 435 398 B1**
(45) Date de publication et mention de la délivrance du brevet: **26.04.1995**
(21) Numéro de dépôt: 90203411.5
(22) Date de dépôt: 18.12.1990
(51) Int. Cl.: H01L 31/12, H01L 31/16, G02B 6/42

(54) **Photo-coupleur pour montage en surface**
Oberflächenmontierbarer Photokoppler
Surface mounting photocoupler

(30) Priorité: 29.12.1989 FR 8917453
(43) Date de publication de la demande: 03.07.1991
(73) Titulaire: PHILIPS COMPOSANTS, 92150 Suresnes (FR); Philips Electronics N.V., 5621 BA Eindhoven (NL)
(72) Inventeur: Thillays, Jacques, Société Civile S.P.I.D., F-75008 Paris (FR)
(74) Mandataire: Charpail, François

(56) Documents cités:
- FR-A- 2 356 281
- FR-A- 2 392 497
- FR-A- 2 621 708
- US-A- 4 257 058
- US-A- 4 776 659

## Description

La présente invention a pour objet un photo-coupleur pour montage en surface.

Les photo-coupleurs rassemblent sous un même boîtier un élément photo-émetteur et un élément photo-récepteur (voir, par exemple, US-A- 4 776 659). Leur fonction est de découpler électriquement des circuits échangeant des signaux et un élément principal de leur caractéristique est la tension d'isolement, dont la valeur dépend de la distance qui sépare l'émetteur du récepteur. Or, les boîtiers mettent en oeuvre des supports à performances d'isolement électrique élevées et qui sont coûteux (céramique etc. .). Augmenter les dimensions pour augmenter la tension d'isolement revient alors cher.

L'invention a pour objet un photo-coupleur pour montage en surface à tension d'isolement élevée et qui peut être réalisé à moindre coût.

Le photo-coupleur selon l'invention est ainsi caractérisé en ce qu'il comprend un premier support comportant un élément photo-émetteur monté sur une face principale dudit support, un deuxième support comportant un élément photo-récepteur monté sur une face principale dudit support, et un boîtier d'assemblage électriquement isolant dans lequel le premier et le deuxième support sont assemblés, de préférence par encliquetage, dans une direction longitudinale du boîtier d'assemblage de telle sorte que l'élément photo-émetteur et l'élément photo-récepteur soient en face l'un de l'autre, et en ce que le premier et le deuxième support présentent chacun une face inférieure latérale pourvue de pistes conductrices en contact électrique avec lesdits éléments respectifs permettant le montage en surface du photocoupleur.

Le boîtier d'assemblage assure une fonction d'espacement entre les deux supports ce qui permet d'obtenir l'isolation électrique élevée qui est désirée. Par contre, le boîtier d'assemblage est une pièce de faible coût.

Le boîtier d'assemblage peut présenter deux parties assemblées entre elles selon une direction transversale. Ceci permet de rendre les deux parties assemblées particulièrement simples à mouler.

Le boîtier d'assemblage présente, selon un mode de réalisation préféré, au moins un évidement disposé de manière à recevoir une colle d'assemblage, destinée à maintenir le photo-coupleur à plat sur un circuit, par exemple un circuit imprimé, pour une phase ultérieure de soudure.

L'invention sera mieux comprise à la lecture de la description qui va suivre, donnée à titre d'exemple non limitatif, en liaison avec les dessins qui représentent :
- la figure 1, une vue en perspective d'un photo-coupleur selon l'invention.
- les figures 2a, 2b et 2c, respectivement, en vue latérale un demi-boîtier d'assemblage, en coupe transversale, selon BB un boîtier d'assemblage, et en coupe longitudinale partielle A, un boîtier d'assemblage.
- les figures 3a, 3b et 4, un support respectivement en vue latérale gauche, en vue latérale droite et en vue de dessous.

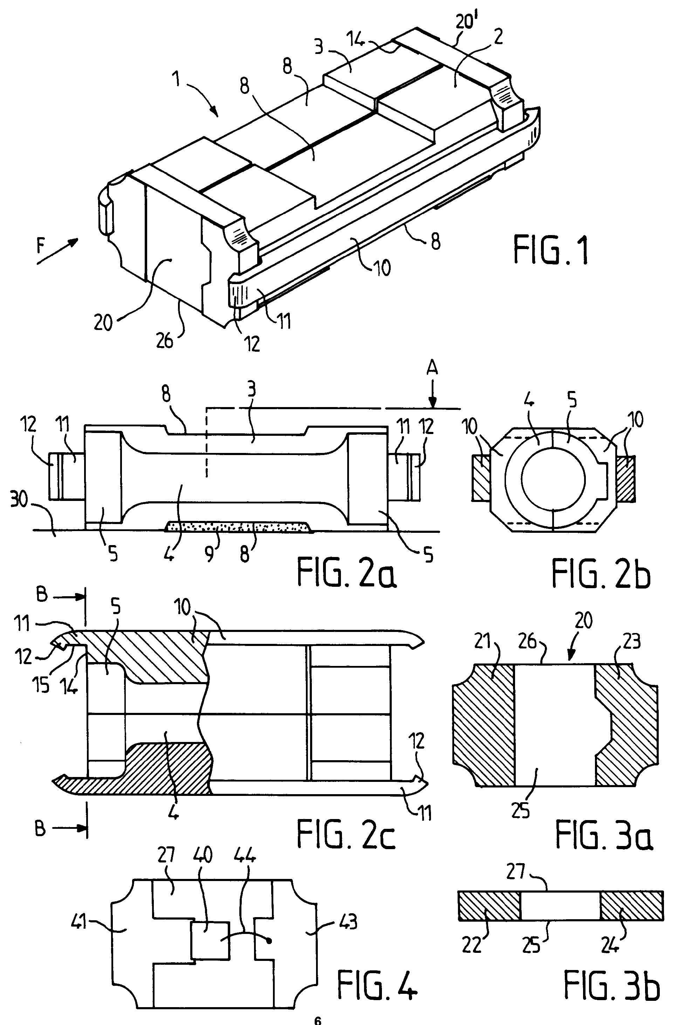

Selon la figure 1, un boîtier d'assemblage 1 de forme allongée en matériau électriquement isolant présente des faces latérales 14 contre lesquelles des supports 20 et 20′ sont maintenus en butée à l'aide de dispositifs d'encliquetage 11, 12 par assemblage selon une direction longitudinale de boîtier 1 (flèche F). Un des supports 20 comporte un élément photo-émissif et l'autre support 20′ comporte un élément photo-récepteur. L'encliquetage et la mise en butée permettent d'assurer que les axes optiques des deux éléments soient pratiquement le même. Le boîtier d'assemblage 1 présente une ouverture centrale cylindrique ou rectangulaire 4 pour le passage des rayons lumineux, se prolongeant aux deux extrémités longitudinales par deux logements 5 permettant de recevoir les éléments et leurs connexions électriques ainsi que leurs éventuels éléments de couplage optique. La longueur du boîtier d'assemblage permet d'assurer la tension d'isolement électrique désirée et est donc choisie pour satisfaire à ce paramètre. En outre, le boîtier d'assemblage 1 comporte sur l'une de ses surfaces supérieure ou inférieure un évidement 8 permettant de recevoir de la colle de fixation 9 du photo-coupleur sur un circuit imprimé 30 en vue d'une opération de soudure à la vague des contacts 22 et 24 des supports 20 et 20′.

Les supports 20 et 20′ de préférence identiques entre eux sont représentés plus particulièrement aux figures 3a, 3b et 4. Sur leur face supérieure 27, un élément opto-électronique 40, soit photo-émetteur, soit photo-récepteur est monté, ses deux électrodes étant en contact électrique avec deux métallisations dont l'une est en contact électrique avec une métallisation 22 d'une face latérale 26 et l'autre avec une métallisation 24 espacée de la métallisation 22 sur la même face latérale 26. La face inférieure 25 du support 20 ou 20′ peut comporter des métallisations 21 et 23, respectivement en contact électrique avec les métallisations 22 et 24. Les métallisations 21 et 23 peuvent servir à des fins de test lorsque le photo-coupleur est monté ou bien encore peuvent servir de métallisation pour le montage en surface d'un support 20 ou 20′ utilisé seul c'est-à-dire sans boîtier 1.

La face supérieure 27 du support 20 ou 20′ comporte deux métallisations 41 et 43 en continuité électrique respectivement avec les métallisations, 22 et 24. Un élément 40 est en contact électrique par sa face inférieure avec la métallisation 41. La deuxième connexion électrique de l'élément 40 est réalisée par un fil 44 entre sa face supérieure et la métallisation 43.

On remarquera que sur les figures, on a représenté deux évidements 8' l'un à la face supérieure, l'autre à la face inférieure du boîtier 1. Ceci n'a d'autre but que de symétriser celui-ci de manière en particulier à le réaliser sous forme de deux demi-boîtiers 2 et 3 séparés selon un plan longitudinal du boîtier 1 et pouvant être facilement assemblés selon une direction transversale. La réalisation d'un boîtier 1 sous forme de deux demi-boîtiers 2 et 3, moulés par exemple en matière plastique, et de préférence identiques entre eux est alors particulièrement économique.

En outre, les supports 20 (par exemple en céramique) peuvent être de dimensions réduites car non grevées par les problèmes de tension d'isolement élevées entre deux éléments émetteur et récepteur.

On obtient donc un photo-coupleur à performances élevées, facile à fabriquer et peu coûteux.

Lorsque les supports 20 et 20′ sont assemblés sur le boîtier 1, ils sont maintenus en butée 14 par les dispositifs d'encliquetage 12 et latéralement par les faces 15 des bras d'encliquetage 11. Les métallisations 22 et 24 des deux supports 20 sont disposés dans le prolongement de la même face dite inférieure du boîtier 1, ce qui permet le montage en surface.

Des matériaux convenant particulièrement à la réalisation du boîtier d'assemblage sont par exemple un polyamide 4-6 chargé d'oxyde de titane (connu sous la marque STANYL de la Société néerlandaise DSM) ou bien encore un polymère dit "à cristaux liquides" chargé de fibre de verre et d'oxyde de titane (connus sous la marque VECTRA de la société américaine CELANESE).

L'ouverture centrale 4 peut être réfléchissante et dans ce cas, de section préférentiellement cylindrique avec un diamètre adapté à un fonctionnement de type conduit de lumière. Un élément opto-électronique 40 peut être disposé au foyer d'une lentille de manière à améliorer le rendement lumineux. L'ouverture centrale 4, qu'elle soit ou non réfléchissante, peut être remplie d'une résine transparente de manière à augmenter le couplage lumineux. La résine est préférentiellement d'un type agencé pour remplir l'ouverture 4 par capillarité, par exemple la résine "porétanche 290" de LOCTITE, qui est dix fois plus fluide que l'eau. La résine présente en outre l'avantage de fixer en position les supports 20 par collage.

## Revendications

1. Photocoupleur pour montage en surface caractérisé en ce qu'il comprend un premier support (20) comportant un élément photo-émetteur monté sur une face principale dudit support (20), un deuxième support (20′) comportant un élément photo-récepteur monté sur une face principale dudit support (20′) et un boîtier d'assemblage (1) électriquement isolant dans lequel le premier et le deuxième support (20) sont assemblés (11, 12) dans une direction longitudinale (F) du boîtier d'assemblage de telle sorte que l'élément photo-émetteur et l'élément photo-récepteur soient en face l'un de l'autre, et en ce que le premier et le deuxième support (20) présentent chacun une face inférieure latérale (26) pourvue de pistes conductrices (22, 24) en contact électrique avec lesdits éléments respectifs permettant le montage en surface du photocoupleur.

2. photocoupleur selon la revendication 1, caractérisé en ce que l'assemblage est réalisé par encliquetage.

3. Photocoupleur selon l'une des revendications 1 ou 2, caractérisé en ce que le boîtier d'assemblage présente deux parties (2, 3) assemblées entre elles selon une direction transversale.

4. Photocoupleur selon la revendication 3, caractérisé en ce que lesdites deux parties (2, 3) sont identiques.

5. Photocoupleur selon une des revendications 1 à 4, caractérisé en ce que le boîtier d'assemblage (1) présente au moins un évidement (8) disposé de manière à recevoir une colle d'assemblage (9) destinée à maintenir le photo-coupleur à plat sur un circuit (30) pour une phase ultérieure de soudure.

6. Photocoupleur selon une des revendications précédentes caractérisé en ce qu'au moins un support (20) est en céramique.

7. Photocoupleur selon une des revendications précédentes caractérisé en ce que le boîtier d'assemblage (1) est en matière plastique.

8. Photocoupleur selon la revendication 7, caractérisé en ce que ladite matière plastique est un polyamide de 4-6 chargé d'oxyde de titane.

9. Photocoupleur selon la revendication 7 caractérisé en ce que ladite matière plastique est un polymère chargé de fibres de verre et d'oxyde de titane.

10. Photocoupleur selon une des revendications précédentes caractérisé en ce que le boîtier d'assemblage présente une ouverture centrale (4) dont la forme est adaptée à un fonctionnement en conduit de lumière.

11. Photocoupleur selon la revendication 10, caractérisé en ce que l'ouverture centrale (4) est réfléchissante.

12. Photocoupleur selon une des revendications 10 ou 11, caractérisé en ce que l'ouverture centrale est remplie de résine transparente.

13. Photocoupleur selon une des revendications précédentes caractérisé en ce que les premier (20) et deuxième (20′) supports sont identiques.

## Patentansprüche

1. Optokoppler zur Oberflächenmontage, dadurch gekennzeichnet, daß er einen ersten Träger (20) mit einem auf einer Hauptfläche dieses Trägers (20) angebrachten, optischen Sender-Element, einen zweiten Träger (20′) mit einem mit einem auf einer Hauptfläche dieses Trägers (20′) angebrachten, optischen Empfänger-Element und ein elektrisch isolierendes Montagegehäuse (1) umfaßt, in dem der erste und der zweite Träger (20) in einer Längsrichtung (F) des Montagegehäuses so montiert sind, daß das optische Sender-Element und das optische Empfänger-Element einander zugewandt sind und daß der erste und der zweite Träger (20) jeweils eine mit mit den jeweiligen Elementen elektrisch leitend verbundenen Leiterbahnen (22, 24) versehene seitliche Unterseite (26) aufweisen, um die Oberflächenmontage des Optokopplers zu ermöglichen.

2. Optokoppler nach Anspruch 1, dadurch gekennzeichnet, daß die Montage durch Einrasten realisiert wird.

3. Optokoppler nach Anspruch 1 oder 2, dadurch gekennzeichnet, daß das Montagegehäuse zwei Teile (2, 3) aufweist, die miteinander in Querrichtung montiert sind.

4. Optokoppler nach Anspruch 3, dadurch gekennzeichnet, daß die genannten zwei Teile (2, 3) identisch sind.

5. Optokoppler nach einem der Ansprüche 1 bis 4, dadurch gekennzeichnet, daß das Montagegehäuse (1) mindestens eine Aussparung (8) enthält, die zur Aufnahme eines Montageklebstoffes (9) angeordnet ist, um den Optokoppler für eine spätere Lötphase flach auf einer Schaltung (30) festzuhalten.

6. Optokoppler nach einem der vorhergehenden Ansprüche, dadurch gekennzeichnet, daß mindestens ein Träger (20) aus Keramik ist.

7. Optokoppler nach einem der vorhergehenden Ansprüche, dadurch gekennzeichnet, daß das Montagegehäuse (1) aus Kunststoff ist.

8. Optokoppler nach Anspruch 7, dadurch gekennzeichnet, daß der genannte Kunststoff ein mit Titanoxid durchsetztes 4-6-Polyamid ist.

9. Optokoppler nach Anspruch 7, dadurch gekennzeichnet, daß der genannte Kunststoff ein mit Glasfasern und Titanoxid durchsetztes Polymer ist.

10. Optokoppler nach einem der vorhergehenden Ansprüche, dadurch gekennzeichnet, daß das Montagegehäuse eine zentrale Öffnung (4) aufweist, deren Form an einen Lichtleitbetrieb angepaßt ist.

11. Optokoppler nach Anspruch 10, dadurch gekennzeichnet, daß die zentrale Öffnung (4) reflektierend ist.

12. Optokoppler nach einem der Ansprüche 10 oder 11, dadurch gekennzeichnet, daß die zentrale Öffnung mit transparentem Harz gefüllt ist.

13. Optokoppler nach einem der vorhergehenden Ansprüche, dadurch gekennzeichnet, daß der erste (20) und der zweite (20′) Träger identisch sind.

## Claims

1. A photocoupler for surface mounting, characterized in that it comprises a first support (20) carrying a phototransmitter element mounted on a main surface of said support (20), a second support (20′) carrying a photoreceiver element mounted on a main surface of said second support (20′), and an electrically insulating assembly 5 housing (1) in which the first and the second support (20) are assembled together (11, 12) in a longitudinal direction (F) of the assembly housing such that the phototransmitter element and the photoreceiver element face one another, and in that the first and the second support (20) each have a lower lateral surface (26) provided with conductor tracks (22, 24) in electrical contact with said respective elements so as to facilitate 10 surface mounting of the photocoupler.

2. A photocoupler as claimed in Claim 1, characterized in that the assembly is realised by a snap connection.

3. A photocoupler as claimed in Claim 1 or 2, characterized in that the assembly housing comprises two parts (2, 3) assembled together in a transverse 15 direction.

4. A photocoupler as claimed in Claim 3, characterized in that said two parts (2, 3) are identical.

5. A photocoupler as claimed in any one of the Claims 1 to 4, characterized in that the assembly housing (1) comprises at least one recess (8) arranged to receive an 20 assembly glue (9) which has for its object to keep the photocoupler flat against a circuit (30) for a subsequent soldering step.

6. A photocoupler as claimed in any one of the preceding Claims, characterized in that at least one support (20) is made of ceramic material.

7. A photocoupler as claimed in any one of the preceding Claims, 25 characterized in that the assembly housing (1) is made of synthetic resin material.

8. A photocoupler as claimed in Claim 7, characterized in that said synthetic resin material is a 4-6 polyamide charged with titanium oxide.

9. A photocoupler as claimed in Claim 7, characterized in that said synthetic resin material is a polymer charged with glass fibres and titanium oxide.

10. A photocoupler as claimed in any one of the preceding Claims, characterized in that the assembly housing comprises a central opening (4) whose shape is adapted to function as a light waveguide.

11. A photocoupler as claimed in Claim 10, characterized in that the central opening (4) is reflecting.

12. A photocoupler as claimed in Claim 10 or 11, characterized in that the central opening is filled with a transparent resin.

13. A photocoupler as claimed in any one of the preceding Claims, characterized in that the first (20) and the second support (20′) are identical.
